(19) Europäisches Patentamt
European Patent Office
Office européen des brevets

(11) Veröffentlichungsnummer: **0 316 591 B1**

(12) **EUROPÄISCHE PATENTSCHRIFT**

(45) Veröffentlichungstag der Patentschrift: **08.12.93**

(51) Int. Cl.$^5$: **C08K 5/57**, C08L 83/04

(21) Anmeldenummer: **88117221.7**

(22) Anmeldetag: **17.10.88**

# (54) Unter Abspaltung von Oximen härtende 1 K RTV Massen.

(30) Priorität: **29.10.87 DE 3736654**

(43) Veröffentlichungstag der Anmeldung:
**24.05.89 Patentblatt 89/21**

(45) Bekanntmachung des Hinweises auf die Patenterteilung:
**08.12.93 Patentblatt 93/49**

(84) Benannte Vertragsstaaten:
**AT BE CH DE ES FR GB GR IT LI LU NL SE**

(56) Entgegenhaltungen:
**EP-A- 0 090 409**
**EP-A- 0 208 963**
**US-A- 3 839 246**
**US-A- 3 956 209**

(73) Patentinhaber: **BAYER AG**

**D-51368 Leverkusen(DE)**

(72) Erfinder: **Jeremias, Jörg**
**Immanuel-Kant-Strasse 17**
**D-5060 Bergisch-Gladbach 1(DE)**
Erfinder: **Metzinger, Hans-Gerd, Dr.**
**Morsbroicher Strasse 67**
**D-5090 Leverkusen 1(DE)**
Erfinder: **Preuss, Krystyna**
**Vincent-van-Gogh-Strasse 32**
**D-5090 Leverkusen 1(DE)**
Erfinder: **Weber, Wilhelm, Dr.**
**Rybniker Strasse 12**
**D-5000 Köln 80(DE)**

EP 0 316 591 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Einkomponenten-Siliconpasten, die im Kontakt mit der Luftfeuchtigkeit unter Abspaltung von Oximen aushärten, gut auf vielen Untergründen haften, gute Lagerstabilität sowie gute mechanische Eigenschaften im vulkanisierten Zustand besitzen und Metalloberflächen, insbesondere Kupfer, nicht angreifen.

Eine der bekannten Methoden, feuchtigkeitshärtende Siliconpasten herzustellen, beruht auf der Verwendung von Oximinosilanen. Silane dieser Art werden in der US-PS 3 189 576 beschrieben. Man vermischt $\alpha,\omega$-Dihydroxypolydimethylsiloxane mit dem jeweiligen Oximinosilan und gegebenenfalls einem oder mehreren Füllstoffen. Auf diese Weise erhält man kalthärtende Systeme (sog. RTV-Systeme), die unter Ausschluß von Luftfeuchtigkeit gelagert werden können und die unter dem Einfluß der Luftfeuchtigkeit gelagert werden können und die unter dem Einfluß der Luftfeuchtigkeit zu einem Elastomer aushärten, sogenannte Oximsysteme.

Es ist weiterhin bekannt geworden, daß man die Vernetzung von Oximsystemen durch Metallkatalysatoren, insbesondere von Dialkylzinndicarboxylaten, beschleunigen kann. Für die Anwendung als Dichtstoff ist außerdem die Verwendung von Aminoalkylalkoxysilanen, beispielsweise $H_2N\ CH_2CH_2CH_2\ Si(OC_2H_5)_3$ oder $H_2N\ CH_2CH_2\ NH\ CH_2CH_2CH_2Si(OCH_3)_3$ beschrieben worden. Solche Silane verbessern die Haftung auf vielen Untergründen. Systeme, die aus $\alpha,\omega$-Dihydroxypolydimethylsiloxanen, Oximinosilanen, Aminoalkylalkoxysilanen, Dialkylzinndicarboxylaten und Füllstoffen hergestellt werden, sind Gegenstand der japanischen Patentanmeldung 46-11272.

In einer weiteren Patentschrift EP-PS 90 409, werden Formulierungen beschrieben, die denen in der genannten japanischen Anmeldung ähneln. Es werden darin Zinnkatalysatoren eingesetzt, die durch die Umsetzung von Dialkylzinndicarboxylaten mit Alkoxysilan unter Abspaltung von Carbonsäureestern entstehen.

In der DE-PS 3 524 452, schließlich, werden Oximsysteme beschrieben, die neben Aminoalkylalkoxysilanen und Dibutylzinndicarboxylaten kleinere Mengen von Carbonsäuren oder deren Silanderivaten enthalten. Diese Zusätze bewirken eine Beschleunigung der Vernetzung unter dem Einfluß von Luftfeuchtigkeit.

Die nach dem Stand der Technik erhältlichen Produkte weisen Nachteile auf. Formulierungen nach der japanischen Patentschrift 46-11272 oder der deutschen Patentschrift 3 524 452, die Dialkylzinndicarboxylate enthalten, sind zwar als Dichtstoffe einsetzbar, können aber auf Metallen, insbesondere auf Kupfer, Verfärbungen und andere Korrosionserscheinungen hervorrufen.

Formulierungen nach der europäischen Patentschrift 90 409 verhalten sich günstiger bei Anwendung auf Kupferoberflächen. Bei den dort beschriebenen Formulierungen beobachtet man jedoch oft eingeschränkte Lagerfähigkeit im unvulkanisierten Zustand.

Es bestand also die Aufgabe, Oximsysteme zu finden, die eine gute Lagerstabilität aufweisen und Metalloberflächen, insbesondere Kupfer, nicht angreifen.

Gegenstand der Erfindung sind unter Ausschluß von Feuchtigkeit lagerfähige und bei Zutritt von Feuchtigkeit rasch härtende Polyorganosiloxanmassen, erhältlich durch Vermischen von

(1) 100 Gew.-Tln. eines $\alpha,\omega$-Dihydroxypolydimethylsiloxansmit einer Viskosität zwischen 0,1 und 1000 Pas,

(2) 0 bis 100 Gew.-Tln. eines $\alpha,\omega$-Bis(trimethylsiloxy)-polydimethylsiloxane mit einer Viskosität zwischen 0,04 und 10 Pas als Weichmacher

(3) 1 bis 10 Gew.-Tln. eines Oximinosilans der Zusammensetzung

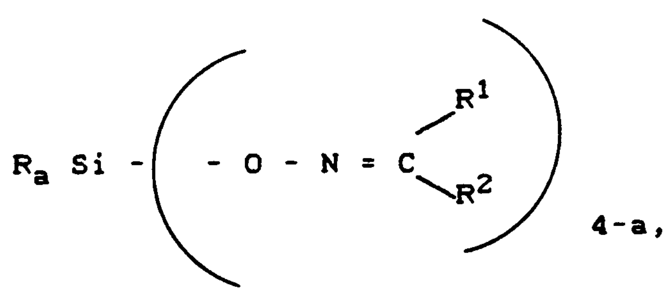

wobei R Alkyl oder Alkenylreste mit 1 bis 4 C-Atomen sind, $R^1$ und $R^2$ jeweils ein Alkylrest mit 1 bis 4 C-Atomen oder Wasserstoff sein kann oder $R^1$ und $R^2$ zusammen einen Alkylenrest mit 4 oder 5 C-Atomen bedeuten und wobei a die Werte 0 oder 1 annehmen kann,

(4) 5 bis 250 Gew.-Tln. eines verstärkenden oder eines nicht verstärkenden Füllers oder eines Füllstoffgemisches,

(5) 0 bis 2,5 Gew.-Tln. eines Aminoalkylalkoxysilans das einen oder mehrere über mindestens 3 C-Atome mit einem Silicium verbundene basische Stickstoffatome enthält und

(6) 0,01 bis 0,5 Gew.-Tln. Zinn in Form eines Zinnkatalysators,

welche dadurch gekennzeichnet sind, daß man Lösungen von Dialkylzinnoxiden der Zusammensetzung

$R^3_2$ SnO

in Aminoalkylalkoxysilanen, wie unter (5) definiert, einsetzt, wobei $R^3$ lineare oder verzweigte Alkylreste mit 3 bis 18 C-Atomen sein können.

Es war überraschend, daß bei der erfindungsgemäßen Verwendung der Lösung von Dialkylzinnoxiden in Aminoalkylalkoxysilanen die geforderte Eigenschaftskombination erzielt wird.

Dialkylzinnoxide wurden zwar bereits in anderem Zusammenhang in der Literatur als Katalysatoren für 1 K-RTV Massen erwähnt. In der Praxis, insbesondere bei der Herstellung von Oximsystemen, sind sie jedoch bisher nicht bekannt geworden. Es kann vermutet werden, daß dies vor allem in der geringen Löslichkeit der Dibutylzinnoxide in Siliconölen begründet ist. Durch den Einsatz der erfindungsgemäßen Katalysatormischungen in Oximsystemen war daher weder eine Verminderung der Korrosivität gegenüber Metallen, insbesondere Kupfer, zu erwarten noch die gute Lagerstabilität, beispielsweise im Vergleich zu Zinnkatalysatoren, die durch Erhitzen von Dialkylzinndicarboxylaten mit Alkoxysilanen unter Abspaltung von Carbonsäureestern entstehen.

Die als die Bestandteile (1) und (2) genannten Polydimethylsiloxane mit Hydroxy- bzw. Trimethylsiloxy-Endgruppen sind bekannt und handelsüblich. Darüber hinaus sollte sich die Erfindung auch auf Polysiloxane anwenden lassen, die neben Methylresten noch andere Substituenten, beispielsweise Phenylgruppen, enthalten.

Als Oximinosilane (3) eignen sich Verbindungen wie $CH_2Si\ [O\ N = C(C_2H_5)\ CH_3]_3$, $CH_2 = CH\ Si\ (O\ N = C(C_2H_5)\ CH_3]_3$, $CH_3Si\ [O\ N = C(CH_3)_2]$, $C_2H_5\ Si\ (O\ N = CH\ CH_3)_3$, $Si[O\ N = C(C_2H_5)_2]_4$, $Si[ON=-(CH_2CH_5)CH_3]_4$ und

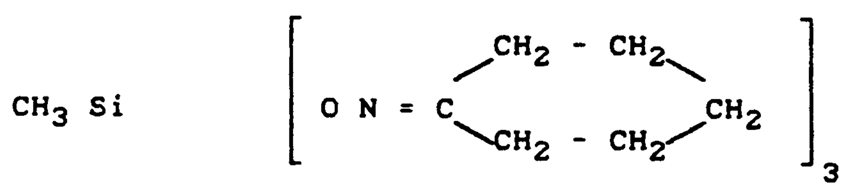

oder Gemische solcher Silane.

Die Substanzen und deren Herstellung wurden in der US-PS 3 189 576 beschrieben. Methyltris-(butanonoximino)-silan ist besonders bevorzugt.

Als Füllstoffe (4) kommen verstärkende Füllstoffe wie pyrogene und gefällte Kieselsäure und nicht oder wenig verstärkende mineralische Materialien wie Carbonate (Kreide, Dolomit), Silicate (Ton, Schiefermehl, Glimmer, Talc, Wollastonit), $SiO_2$ (Quarz, Diatomeenerde) sowie Ruß in Frage. Die Oberflächen der Füller können durch bekannte Hydrophobierungsmittel, wie langkettige Carbonsäuren und reaktionsfähige Silane, modifiziert sein.

Als Aminoalkylalkoxysilane (5) eignen sich Verbindungen wie $H_2NCH_2CH_2H_2Si(OC_2H_5)_3$, $H_2N\ CH_2CH_2NH\text{-}CH_2CH_2CH_2Si(OCH_3)_3$ und $H_2NCH_2CH_2CH_2SiCH_3(OC_2H_5)_2$. Es können jedoch auch andere Aminoalkylalkoxysilane zur Herstellung der erfindungsgemäßen Massen benutzt werden. Eine Vielzahl solcher Verbindungen ist als Haftmittel oder als Vernetzer für Siliconsysteme beschrieben worden, als Beispiel hierfür kann die US-PS 3 888 815 genannt werden.

Als Dialkylzinnoxide eignen sich Verbindungen wie $(n\text{-}C_4H_9)_2SnO$, $(n\text{-}C_6H_{13})_2SnO$, $(n\text{-}C_8H_{17})_2SnO$ und $[C_4H_9(C_2H_5)CH]_2SnO$. Dibutylzinnoxid und Dioctylzinnoxid sind besonders bevorzugt.

Die Lösungen der Dialkylzinnoxide in Aminoalkylalkoxysilanen erhält man durch Mischen der Bestandteile und Erhitzen auf etwa 150 °C. Es muß mindestens 0,5 mol Aminosilan pro Mol Dialkylzinnoxid verwendet werden. Ein Überschuß an Aminosilan begünstigt den Auflösungsprozeß. Die Verwendung von Lösungsmitteln ist möglich, jedoch nicht erforderlich.

Das Aminoalkylalkoxysilan kann bei der Herstellung des Dichtstoffs vollständig in Form der Lösung von Dibutylzinnoxid in dem Silan selbst zugegeben werden. Es kann aber auch ohne nachteilige Folgen weiteres Silan zudosiert werden. Besonders bevorzugt sind Gesamtkonzentrationen an Aminoalkylalkoxysilan zwischen 0,2 und 1,0 % bezogen auf den fertigen Dichtstoff. Die besonders bevorzugten Zinnkonzentrationen liegen zwischen 0,05 und 0,15 %.

Die erfindungsgemäßen Massen können, wie bei feuchtigkeitshärtenden Siliconpasten üblich, in Planetenmischern, Butterfly-Mischern, Disolvern, kontinuierlich arbeitenden Mischschnecken oder anderen für die Pastenherstellung geeigneten Geräten hergestellt werden. Die Produkte werden in luftdicht verschließbare Gebinde, beispielsweise Kartuschen, abgefüllt. Beim Herstellungsprozeß muß Kontakt mit der Luftfeuchtigkeit so weit wie möglich vermieden werden.

Die erfindungsgemäßen Massen können Verwendung finden bei Verklebungen und Beschichtungen im Kontakt mit Metallen, insbesondere Kupfer. Als Beispiel können Elektronikanwendungen genannt werden.

Die folgenden Beispiele sollen die Erfindung näher erläutern.

## Beispiel 1

50,7 g Dibutylzinnoxid wurden unter trockenem Argon in 70,3 g 3-Aminopropyltriethoxysilan suspendiert und unter Rühren im Verlauf von 90 Minuten auf 150 °C erhitzt. Die Temperatur wurde 30 Minuten gehalten. Es entstand eine Flüssigkeit, aus der sich nach dem Abkühlen kein Feststoff mehr ausschied.

## Beispiel 2

62 Gew.-Tle. eines $\alpha,\omega$-Dihydroxypolydimethylsiloxans der Viskosität 50 Pa.s und 23,1 Gew.-Tle, eine $\alpha,\omega$-Bis(trimethylsiloxy)polydimethylsiloxans der Viskosität 0,1 Pa.s wurden in einem Planetenmischer mit 5,3 Gew.-Tln. $CH_3Si\ [ON = C(C_2H_5)CH_3]_3$ und mit 8,4 Gew.-Tln. einer hydrophobierten pyrogenen Kieselsäure (BET-Oberfläche 110 $m^2/g$) vermischt. Danach wurden 0,7 Gew.-Tle. $H_2NCH_2CH_2CH_2Si(OC_2H_5)_3$ und 0,35 Gew.-Tle. der im Beispiel 1 erhaltenen Lösung zugesetzt.

Zur Prüfung des Verhaltens gegenüber Kupfer wurde die Masse in Form einer etwa 1 cm dicken Raupe auf ein Kupferblech aufgetragen. Nach 3 Tagen war noch keine Farbveränderung auf der Kupferoberfläche zu erkennen.

Die Prüfung der mechanischen Festigkeit ergab nach 14-tägiger Aushärtung bei 25 °C und 50 % rel. Luftfeuchtigkeit die folgenden Werte (DIN 53 504):

| | | |
|---|---|---|
| Härte | : | 21 Shore A |
| E-Modul | : | 0,47 $N/mm^2$ |
| Reißfestigkeit | : | 1,5 $N/mm^2$ |
| Bruchdehnung | : | 450 % |

Der Dichtstoff wurde außerdem in Form von etwa 1 cm dicken Raupen auf Glas-, Kachel-, Aluminium-, Kupfer-, Hart-PVC- und Makrolonplatten aufgetragen. Nach 7 Tagen Aushärung wurde geprüft, ob der Dichtstoff adhäsiv vom Untergrund abriß. Dies war bei keinem der Untergründe der Fall. Eine zweite Reihe von vergleichbaren Prüfplatten wurde nach dem Aushärten des Dichtstoffes 1 Woche lang bei Raumtemperatur unter Wasser gelagert. Auch nach dieser Wasserbelastung wurde kein adhäsives Abreißen beobachtet.

Zur Prüfung der Lagerestabilität der Paste wurde ein Kurztest durchgeführt. Hierzu wurde das Material in Tuben abgefüllt, bei 100° gelagert und täglich durch Ausspritzen einer kleinen Menge auf beginnende Vergelung und auf Vernetzungsfähigkeit geprüft. Der Dichtstoff war nach 6 Tagen bei 100° noch nicht vergelt und härtete noch einwandfrei zu einem elastischen Vulkanisat.

## Beispiele 3 bis 5

Beispiel 2 wurde wiederholt mit dem Unterschied, daß die in Tabelle 1 angegebenen Zinnlösungen und Aminosilane verwendet wurden. Die Zusammensetzung der Zinnlösungen ist Tabelle 2 zu entnehmen. Die Prüfungen erfolgten wie in Beispiel 2 beschrieben. Die Ergebnisse sind in Tabelle 1 zusammengefaßt.

Vergleichsbeispiel 6

Beispiel 2 wurde wiederholt mit dem Unterschied, daß 0,9 Gew.-Teile 3-Aminopropyltriethoxysilan eingesetzt wurden und anstelle der erfindungsgemäßen Zinnlösung 1,7 Gew.-Teile einer Katalysatormischung verwendet wurden, die wie folgt hergestellt wurden war.

21,8 g Dibutylzinndilaurat wurden mit 78,2 g Tetraethoxysilan 1,5 Stunden lang auf 150 °C erhitzt. Nach dieser Zeit waren die Lauratreste am Zinn praktisch quantitativ zu Laurinsäuerethylester abreagiert (Ergebnis Tab. 1).

**Tabelle 1**

Die Mengenangaben beziehen sich auf Ansätze wie in Beispiel 2. Die aufgeführten Mengen an Zinnlösungen und Aminosilanen wurden anstelle der dort genannten Zinnlösung aus Beispiel 1 und anstelle der 3-Aminopropyltriethoxysilanmenge verwendet.

| Beispiel | Zinnlösung | Aminosilan | Vernetzung nach 6 Tagen bei 100°C | Verfärbung der Kupferoberfläche | Mechanische Eigenschaften (DIN 53 504) ZF | BD | E-Mod |
|---|---|---|---|---|---|---|---|
| 3 | 0,37 Gew.-Tle. A | 0,76 Gew.-Tle. $H_2NCH_2CH_2CH_2Si(OC_2H_5)_3$ | ja | nein | 1,3 | 420 | 0,44 |
| 4 | 0,35 Gew.-Tle. B | 0,70 Gew.-Tle. $H_2NCH_2CH_2CH_2SiCH_3(OC_2H_5)_2$ | ja | nein | 1,3 | 440 | 0,43 |
| 5 | 0,35 Gew.-Tle. C. | 0,70 Gew.-Tle. $H_2NCH_2CH_2NHCH_2CH_2CH_2Si(OCH_3)_3$ | ja | nein | 1,6 | 590 | 0,41 |
| Vergleichsbeispiel 6 | | | nein | nein | 1,5 | 410 | 0,51 |
| Vergleichsbeispiel 7 | | | ja | ja | 1,0 | 230 | 0,55 |
| Vergleichsbeispiel 8 | | | ja | ja | 1,5 | 470 | 0,46 |

ZF = Zugfestigkeit in $N/mm^2$, BD = Bruchdehnung in %, E-Mod= Zugspannung bei 100% Dehnung in $N/mm^2$

Tabelle 2

**Zusammensetzung der Zinnlösungen von Beispiel 3 bis 5.**

A: 78 g Dioctylzinnoxid 50 g $H_2NCH_2CH_2CH_2Si(OC_2H_5)_3$

B: 51 g Dibutylzinnoxid 70 g $H_2NCH_2CH_2CH_2SiCH_3(OC_2H_5)_2$

C: 51 g Dibutylzinnoxid 70 g $H_2NCH_2CH_2NHCH_2CH_2CH_2Si(OCH_3)_3$

Vergleichsbeispiel 7

Beispiel 2 wurde so abgewandelt, daß 0,9 Gew.-Tle. 3-Aminopropyltriethoxysilan verwendet wurden. Als Katalysator wurden 0,19 Gew.-Tle. Dibutylzinndi-2-ethylhexanoat anstatt der erfindungsgemäßen Zinnlösung eingesetzt. Zusätzlich wurden 0,49 Gew.-Tle. 2-Ethylhexansäure als Vulkanisationsbeschleuniger zugegeben (Ergebnis Tab. 1).

Vergleichsbeispiel 8

Beispiel 7 wurde wiederholt, aber die 2-Ethylhexansäure weggelassen und das Dibutylzinndi-2-ethylhexonoat durch 0,21 Gew.-Tle. Dibutylzinndiacetat ersetzt (Ergebnis Tab. 1).

**Patentansprüche**

**1.** Unter Ausschluß von Feuchtigkeit lagerfähige und bei Zutritt von Feuchtigkeit härtende Polyorganosiloxanmassen,erhältlich durch Mischung von

(1) 100 Gew.-Tln. eines $\alpha,\omega$-Dihydroxypolydimethylsiloxansmit einer Viskosität zwischen 0,1 und 1000 Pas,

(2) 0 bis 100 Gew.-Tln. eines $\alpha,\omega$-Bis(trimethylsiloxy)polydimethylsiloxane mit einer Viskosität zwischen 0,04 und 10 Pas als Weichmacher

(3) 1 bis 10 Gew.-Tln. eines Oximinosilans der Zusammensetzung

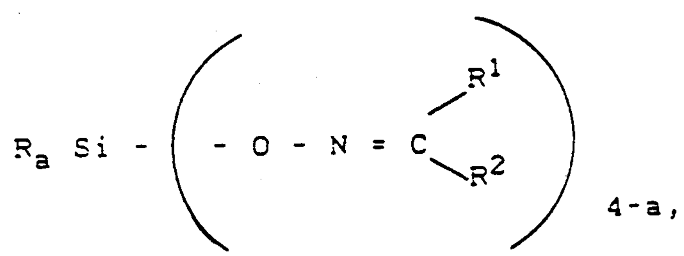

wobei R Alkyl oder Alkenylreste mit 1 bis 4 C-Atomen sind, $R^1$ und $R^2$ jeweils ein Alkylrest mit 1 bis 4 C-Atomen oder Wasserstoff sein kann oder $R^1$ und $R^2$ zusammen einen Alkylenrest mit 4 oder 5 C-Atomen bedeuten und wobei a die Werte 0 oder 1 annehmen kann,

(4) 5 bis 250 Gew.-Tln. eines verstärkenden oder eines nicht verstärkenden Füllers oder eines Füllstoffgemisches,

(5) 0 bis 2,5 Gew.-Tln. eines Aminoalkylalkoxysilans das einen oder mehrere über mindestens 3 C-Atome mit einem Silicium verbundene basische Stickstoffatome enthält und

(6) 0,01 bis 0,5 Gew.-Tln. Zinn in Form eines Zinnkatalysators,

welche dadurch gekennzeichnet sind, daß man den Zinnkatalysator in Form von Lösungen von Dialkylzinnoxiden der Zusammensetzung

$R^3_2 SnO$

in Aminoalkylalkoxysilanen, wie unter (5) definiert, einsetzt, wobei $R^3$ lineare oder verzweigte Alkylreste mit 3 bis 18 C-Atomen sein können, und wobei das molare Verhältnis von Aminoalkylalkoxysilan zu Dialkylzinnoxid mindestens 0,5 beträgt.

## Claims

**1.** Polyorganosiloxane pastes which are storable in the absence of moisture and which cure on contact with moisture, obtainable by mixing

(1) 100 parts by weight of an $\alpha,\omega$-dihydroxypolydimethyl siloxane having a viscosity of 0.1 to 1,000 Pas,

(2) 0 to 100 parts by weight of an $\alpha,\omega$-bis(trimethylsiloxy)polydimethyl siloxane having a viscosity of 0.04 to 10 Pas as plasticizer,

(3) 1 to 10 parts by weight of an oximinosilane having the following composition

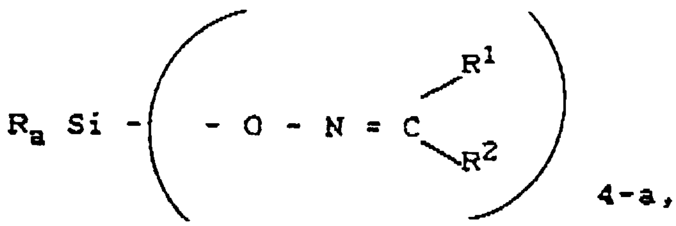

in which R represents $C_{1-4}$ alkyl or alkenyl radicals, $R^1$ and $R^2$ may each represent a $C_{1-4}$ alkyl radical or hydrogen or $R^1$ and $R^2$ together represent a $C_4$ or $C_5$ alkylene radical and a may assume a value of 0 or 1,

(4) 5 to 250 parts by weight of a reinforcing or non-reinforcing filler or filler mixture,

(5) 0 to 2.5 parts by weight of an aminoalkyl alkoxysilane containing one or more basic nitrogen atoms attached to a silicon by at least 3 C atoms and

(6) 0.01 to 0.5 part by weight tin in the form of a tin catalyst,

characterized in that the tin catalyst is used in the form of solutions of dialkyl tin oxides having the composition

$R^3{}_2SnO$

where $R^3$ may represent linear or branched $C_{3-18}$ alkyl radicals,
in aminoalkyl alkoxysilanes as defined in (5),
the molar ratio of aminoalkyl alkoxysilanes to dialkyl tin oxide being at least 0.5.

## Revendications

**1.** Compositions de polyorganosiloxanes entreposables à l'abri de l'humidité et durcissant au contact avec l'humidité, pouvant être obtenues en mélangeant

(1) 100 parties en poids d'un $\alpha,\omega$-dihydroxypolydiméthylsiloxane d'une viscosité de 0,1 à 1000 Pas,

(2) 0 à 100 parties en poids d'un $\alpha,\omega$ -bis-(triméthylsiloxy)polydiméthylsiloxane d'une viscosité de 0,04 à 10 Pas comme assouplissant ou plastifiant,

(3) 1 à 10 parties en poids d'un oximinosilane de composition

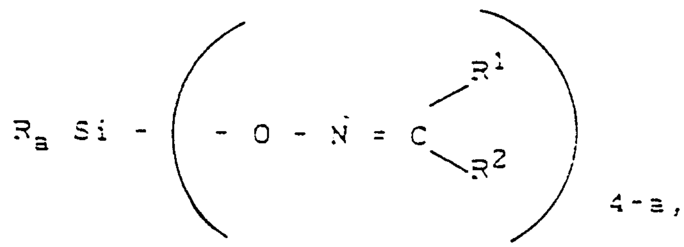

dans laquelle R signifie alkyle ou un reste alcényle avec 1 à 4 atomes de carbone, $R^1$ et $R^2$ signifient chaque fois un reste alkyle avec 1 à 4 atomes de carbone ou peuvent signifier l'hydrogène, ou $R^1$ et $R^2$ signifient ensemble un reste alkyle avec 4 ou 5 atomes de carbone, et a pouvant avoir la valeur 0 ou 1,

(4) 5 à 250 parties en poids d'une charge épaississante ou non épaississante ou d'un mélange de charges,

(5) 0 à 2,5 parties en poids d'un aminoalkylalcoxysilane contenant un ou plusieurs atomes d'azote basique liés par au moins 3 atomes de carbone avec un atome de silicium, et

(6) 0,01 à 0,5 parties en poids d'étain sous forme d'un catalyseur à l'étain,

caractérisées en ce que l'on utilise des catalyseurs à l'étain sous forme de solutions d'oxydes de dialkylétain de composition

$R^3{}_2SnO$

dans des aminoalkylalcoxysilanes, comme ils sont définis en (5), $R^3$ pouvant être un reste alkyle à chaîne droite ou ramifiée avec 3 à 18 atomes de carbone, et le rapport molaire entre l'aminoalhylsiloxane et l'oxyde de dialkylétain étant d'au moins 0,5.